Europäisches Patentamt

European Patent Office

Office européen des brevets

(11) Veröffentlichungsnummer: **0 391 242 B1**

(12) **EUROPÄISCHE PATENTSCHRIFT**

(45) Veröffentlichungstag der Patentschrift: **22.12.93**

(21) Anmeldenummer: **90105970.9**

(22) Anmeldetag: **29.03.90**

(51) Int. Cl.⁵: **G01R 31/36**, H01M 10/42

(54) **Verfahren zur Überwachung des Ladezustandes einer wiederaufladbaren, verschlossenen Batterie.**

(30) Priorität: **04.04.89 DE 3910904**

(43) Veröffentlichungstag der Anmeldung:
**10.10.90 Patentblatt 90/41**

(45) Bekanntmachung des Hinweises auf die
Patenterteilung:
**22.12.93 Patentblatt 93/51**

(84) Benannte Vertragsstaaten:
**DE DK FR GB IT SE**

(56) Entgegenhaltungen:
**EP-A- 0 003 917**
**EP-A- 0 280 916**
**DE-A- 3 106 171**
**DE-A- 3 108 844**

(73) Patentinhaber: **ELEKTRON-BREMEN Fabrik für**
**Elektrotechnik GmbH**
**Am Hohentorshafen 17-19**
**D-28197 Bremen(DE)**

(72) Erfinder: **Seyferth, Wolfhard, Dipl.-Ing.**
**Westersteder Weg 1**
**D-2874 Lemwerder(DE)**

(74) Vertreter: **Möller, Friedrich, Dipl.-Ing. et al**
**Meissner, Bolte & Partner**
**Patentanwälte**
**Hollerallee 73**
**D-28209 Bremen (DE)**

Rank Xerox (UK) Business Services
(3. 10/3.6/3.3. 1)

## Beschreibung

Die Erfindung betrifft ein Verfahren zur Überwachung des Ladezustandes einer wiederaufladbaren, verschlossenen Batterie, wobei zumindest die Klemmenspannung gemessen wird. Vorzugsweise handelt es sich dabei um sogenannte verschlossene Batterien mit festgelegtem Elektrolyten, die in batteriebetriebenen Fahrzeugen, z.B. Gabelstaplern, im intermittierenden Betrieb verwendet werden.

Lange Zeit wurden in batteriebetriebenen Fahrzeugen sogenannte Naßbatterien verwendet. Bei diesem Batterietyp kommt es während des Ladevorgangs durch Gasung zu einer Wasserzersetzung. Die Dichte der in der Batterie enthaltenen Säure erhöht sich dadurch. Eine Zunahme der Säuredichte bedeutet zugleich auch eine Zunahme der Batteriespannung. Das heißt, daß von zwei vollgeladenen Batterien diejenige eine höhere Klemmenspannung aufweist, die durch Wasserverlust eine Säure höherer Dichte enthält. Füllt man das zersetzte Wasser nach und paßt damit auch wieder die Säuredichte an, so entspricht auch die Batteriespannung wieder ihrem Normalwert. Durch das ständig erforderliche Nachfüllen von Wasser sind die Naßbatterien als wartungsanfällig bekannt.

Zur Vermeidung der Wartung sind sogenannte verschlossene Batterien mit festgelegtem Elektrolyt entwickelt worden. Bei diesen Batterien wird aufgrund besonderer Ladeverfahren und der Gasreduktion in den verschlossenen Zellen der Wasserverlust so gering wie möglich gehalten. Der Flüssigkeitsvorrat des Elektrolyten ist für die Lebensdauer der Batterie bemessen. Ein Wassernachfüllen ist nicht mehr möglich. Da die Wasserzersetzung bei verschlossenen Batterien mit festgelegtem Elektrolyt nicht ganz ausgeschlossen werden kann, führt der Wasserverlust mit der Zeit zu einer ansteigenden Säuredichte. Wie bereits oben im Zusammenhang mit den Naßbatterien ausgeführt, nimmt mit der höheren Säuredichte automatisch die Batterie-Klemmenspannung zu.

Unter den beschriebenen Einsatzbedingungen werden üblicherweise Kontrollgeräte eingesetzt, die die Batteriespannung überwachen und auf den Rückgang der Batteriespannung während der Entladung reagieren. Zweck dieser Kontrollgeräte ist die Verhinderung der Unterschreitung einer zulässigen Entladespannung und der damit verbundenen Batterie-Tiefentladung.

Die bei verschlossenen Batterien mit zunehmender Betriebszeit ansteigende Säuredichte und der damit verbundene Batteriespannungsanstieg führen bei bekannten Kontrollgeräten zu verfälschten Abschaltwerten bzw. Tiefentladungen.

Aus der EP-A-0 003 917 sind ein Verfahren und eine Vorrichtung zur Bestimmung der Kapazität einer Speicherbatterie bekannt. Dort wird zunächst eine offene Klemmenspannung und anschließend eine Spannung bei Stromfluß gemessen. Aus der sich ergebenden Differenz wird ein den Stromfluß repräsentierender Wert abgeleitet und auf dieser Basis die Kapazität der Batterie bestimmt.

Aufgabe der vorliegenden Erfindung ist es demnach, ein Verfahren zur Überwachung des Ladezustandes einer verschlossenen Batterie unabhängig vom Alterungszustand zu schaffen, durch das eine Tiefentladung der Batterie sicher vermieden wird.

Erfindungsgemäß wird die Aufgabe durch die kennzeichnenden Merkmale des Anspruchs 1 gelöst. Gemäß der Erfindung wird nach einer Ladung der Batterie jeweils die Klemmenspannung $U_{KL}$ gemessen und bei der Ermittlung des Ladezustands der Batterie berücksichtigt. Auf diese Weise wird eine eventuelle Spannungserhöhung durch eine höhere Säurekonzentration in die Berechnung mit einbezogen und es kann eine für die Batterie äußerst schädliche Tiefentladung vermieden werden.

Bei dem Verfahren nach Anspruch 1 wird zunächst errechnet, inwieweit die Referenzspannung $U_{Ref}$ von der Klemmenspannung $U_{KL}$ nach dem Laden der Batterie abweicht. Diese Differenzspannung $U_{DKL} = U_{KL} - U_{Ref}$ wird zu einer vorher bestimmten Entladeschlußspannung $U_{ES}$ addiert und derart eine korrigierte Entladeschlußspannung $U_{KES} = U_{ES} + U_{DKL}$ berechnet und gespeichert. Schließlich wird zu verschiedenen Zeitpunkten eine Differenz aus Momentanspannung $U_{ti}$ und korrigierter Entladeschlußspannung $U_{KES}$ ermittelt und mit einem festgelegten Grenzwert verglichen. Im Regelfalle ist dieser Grenzwert 0, das heißt für $U_{ti} - U_{KES} < 0$ gilt der Entladezustand als erreicht.

Weitere erfindungswesentliche Merkmale ergeben sich aus den Unteransprüchen. Im folgenden werden bevorzugte Ausführungsformen des erfindungsgemäßen Verfahrens näher erläutert. Es zeigen:

Fig. 1    zwei verschiedene Zellenspannungsverläufe einer Batterie, einmal ausgehend vom geladenen Zustand einer neuen Batterie und ein anderes Mal ausgehend vom geladenen Zustand nach einer Vielzahl von Ladungen;

Fig. 2    ein Kennlinienfeld der Batteriespannung (Spannungsdifferenz) in Abhängigkeit vom Entladegrad bei verschiedenen Entladeströmen.

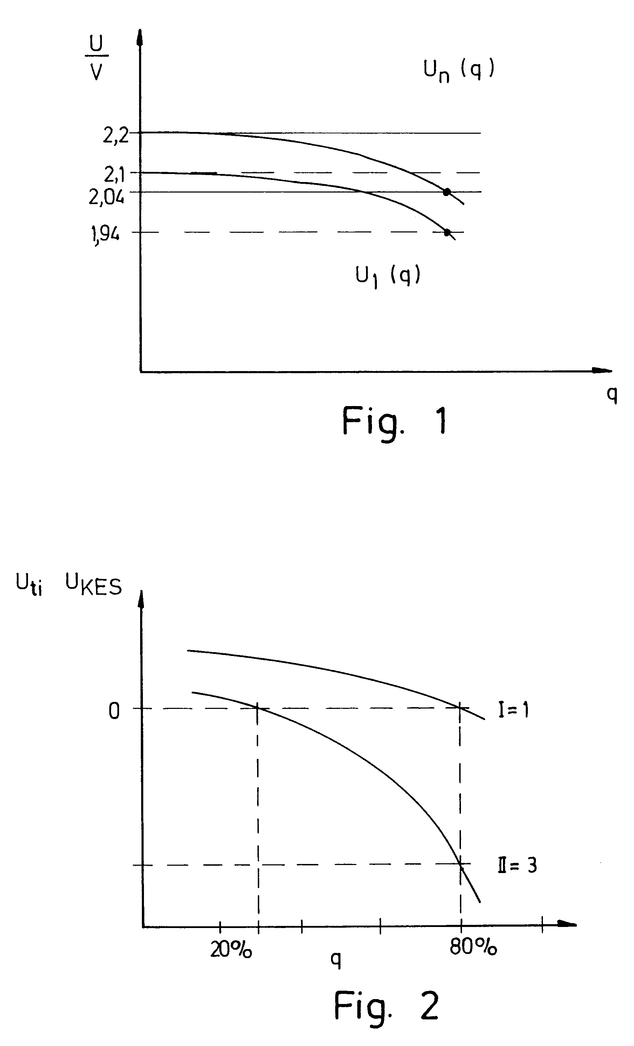

Eine verschlossene Batterie mit festgelegtem Elektrolyt, z.B. eine Gelbatterie, wie sie üblicherweise in elektrisch angetriebenen Flurförderfahrzeugen eingesetzt ist, weist eine Ruhespannung von 2,1 Volt pro Zelle im geladenen Zustand auf. Diese Spannung wird nicht direkt gemessen, sondern an den Batterieklemmen abgenommen und durch die Anzahl der Batteriezellen geteilt. In der Fig. 1 ist der Verlauf der Zellenspannung in Abhängigkeit von der entnommenen Ladung, ausgehend vom Anfangswert 2,1 Volt als Spannungskurve $u_1$ - (q) idealisiert dargestellt. Der Anfangswert von 2,1 Volt pro Zelle entspricht der jeweiligen Batterie-Ruhespannung. Sobald die Zellenspannung - nach Messung der Klemmenspannung und Umrechnung in die Zellenspannung - einen Wert von 1,94 Volt pro Zelle erreicht, die als Entladeschlußspannung $U_{ES}$ gewertet wird, wird die Leistungsabgabe der Batterie unterbrochen und somit eine Tiefentladung verhindert. Nach n Volladungen ist die Zellenspannung im geladenen Zustand aufgrund der erhöhten Säurekonzentration, z.B. auf 2,2 Volt pro Zelle, angestiegen. Der Verlauf der Spannung nach dem n-ten Ladevorgang ist in der Fig. 1 als Kurve mit der Bezeichnung $u_n$ (q) dargestellt. Entsprechend der angehobenen Spannung im geladenen Zustand ist auch die Spannung, die die Grenze zum entladenen Zustand darstellt, anzuheben. Diese untere Grenze (Entladeschlußspannung $U_{ES}$) beträgt demnach in diesem Fall 2,04 Volt pro Zelle. Eine darüber hinausgehende Entladung der Batterie - gestrichelter Teil der Kurve $u_n$ (q) - hätte eine Tiefentladung der Batterie zur Folge.

Zur Vermeidung einer derartigen Tiefentladung wird der Ladezustand der Batterie durch folgende Schritte überwacht:

Nach jeder Ladung der Batterie wird die Klemmenspannung $U_{KL}$ gemessen und als Ruhespannung $U_0$ gespeichert. Im laufenden Betrieb wird dann im unbelasteten Zustand die Momentanspannung $U_{ti}$ an den Klemmen gemessen. Zweckmäßigerweise wird die Messung zyklisch in kurzen Abständen vorgenommen. Nach jeder Messung wird die Differenz aus der Ruhespannung $U_O$ und der Momentanspannung $U_{ti}$ gebildet und mit einem zuvor empirisch ermittelten Wert verglichen. Die im Zusammenhang mit dem Spannungsverlauf von $u_1$ (q) angegebene zulässige Differenz beträgt 2,1 Volt - 1,94 Volt = 0,16 Volt. Das heißt, daß in diesem Fall der Entladezustand als erreicht gilt, sobald die Differenz aus Ruhespannung $U_0$ und Momentanspannung $U_{ti}$ (normiert auf eine Batteriezelle) 0,16 Volt unterschreitet.

In einem anderen Verfahren ist die an einer neuen Batterie üblicherweise anliegende Klemmenspannung als Referenzspannung $U_{Ref}$ abgespeichert. Nach jedem Laden der Batterie wird jeweils die Klemmenspannung $U_{KL}$ (Ruhespannung $U_0$) gemessen und die Differenzspannung $U_{DKL} = U_{KL} - U_{Ref}$ errechnet. Falls $U_{KL} < U_{Ref}$, so wird $U_{DKL} = 0$ gesetzt. Die Messungen werden erst nach einer Mindestbelastung durchgeführt, um die Oberflächenspannung der Batterie abzubauen. Die ermittelte Differenzspannung $U_{DKL}$ wird zur vorher festgelegten oder empirisch bestimmten Entladeschlußspannung $U_{ES}$ addiert und die Summe $U_{KES} = U_{ES} + U_{DKL}$ als korrigierte Entladeschlußspannung gespeichert. Im laufenden Betrieb wird die Momentanspannung $U_{ti}$ zyklisch an den Klemmen gemessen, ihr Mittelwert gebildet (Meßwertsiebung) und das Ergebnis $\overline{U}_{ti}$ der Siebung mit der korrigierten Entladeschlußspannung $U_{KES}$ verglichen. Der Entladezustand gilt als erreicht, sobald $\overline{U}_{ti} < U_{KES}$ oder, in einer anderen Ausführungsform, sobald $\overline{U}_{ti}$ - $U_{KES}$ einen bestimmten Wert unterschreitet.

In einem weiteren Verfahren erfolgt eine Messung bzw. Weiterverarbeitung des Wertes der Momentanspannung $U_{ti}$ nur, wenn die Batterie nicht durch einen Verbraucher belastet wird. Zur Erkennung dieses Zustandes wird zweckmäßigerweise der Momentanstrom $I_{ti}$ gemessen. Sobald $I_{ti}$ nahe O (< 0,5 Ampere) ist, wird die Momentanspannung $U_{ti}$ kontinuierlich oder zeitdiskret abgetastet und wie oben beschrieben verarbeitet.

In einer anderen Ausführungsform wird anstelle der Momentanspannung $U_{ti}$ die Spannung eines von der Klemmenspannung gespeisten Kondensators gemessen. Dem Kondensator sind zum Laden und zum Entladen jeweils eine Diode mit einem vorgeschalteten Widerstand zugeordnet. Die Entladung des Kondensators erfolgt über einen ersten Widerstand und die Ladung des Kondensators vollzieht sich über einen zweiten Widerstand. Die einzelnen Widerstände sind so ausgewählt, daß die Zeitkonstante für den Entladevorgang größer als 1 Minute ist, während die Zeitkonstante für den Ladevorgang im Sekundenbereich liegt, auf jeden Fall aber kleiner ist als die Zeitkonstante für den Entladevorgang. Der Ladezustand kann so auch bei Belastung der Batterie bestimmt werden.

Eine weitere Ausführungsform berücksichtigt die im Inneren der Batterie stattfindenden langsamen Ausgleichsvorgänge. Ist der Batterie über längere Zeit ein hoher Strom entnommen worden, so liegt die in einer folgenden Lastpause angezeigte Klemmenspannung unter dem Wert, der ihrem tatsächlichen Ladezustand entspricht. Erst nach einer gewissen Erholungspause steigt die Klemmenspannung wieder auf einen "normalen", dem Ladezustand entsprechenden Wert an. Die Verfälschung durch diesen Effekt ist um so größer, um so höher der Entnahmestrom ist. Aus diesem Grunde erfolgt, wie in Fig. 2 dargestellt, die Bestimmung des Ladezustands der Batterie in Abhängigkeit vom Entnahmestrom. Während der Belastung der Batterie wird laufend der Momentanstrom gemessen und in einer Lastpause zur Auswahl einer bestimmten Kennlinie aus einer Kennlinienschar herangezogen. In der Fig. 2 ist die Differenz aus Momentanspannung und korrigierter Entladeschlußspannung über dem Entladegrad q abgebildet. Bei einem relativ geringem Entnahmestrom I = 1, bei dem die Ausgleichsvorgänge innerhalb der Batterie der Ladungsabgabe noch recht gut folgen können, ist die Differenz $U_{ti} - U_{KES} = 0$, sobald die Batterie zu 80 % entladen ist. Wollte man diesen Grenzwert ($U_{ti} - U_{KES} = 0$) auch für einen relativ hohen Entnahmestrom I = 3 zugrunde legen, so würde der Entladezustand als erreicht gelten, obwohl die Batterie erst zu etwa 30 % entladen ist. In diesem Fall gilt deshalb der Entladezustand erst dann als erreicht, wenn die Kennlinie für I = 3 die 80 %-Linie von q schneidet. Das heißt, daß der den Entladezustand repräsentierende Grenzwert für die Differenz $U_{ti} - U_{KES}$ sowohl rechnerisch als auch grafisch in der Fig. 2 deutlich unterhalb von 0 liegt.

In einer weiteren bevorzugten Ausführungsform erfolgt die Auswahl der richtigen Kennlinie durch Messung, Speicherung und Mittelung mehrerer Momentanstromwerte.

Entsprechend der zuvor beschriebenen Abhängigkeit vom entnommenen Momentanstrom kann in einem weiteren Verfahrensschritt eine Temperaturabhängigkeit des Ladezustands der Batterie berücksichtigt werden. Die in der Batterie stattfindenden Ausgleichsvorgänge laufen um so schneller ab, je höher die Temperatur ist. Zur Berücksichtigung der Temperatur ist demnach eine Speicherung mehrerer Spannungs-Ladezustands-Kennlinien oder analog zu Fig. 2 Spannungsdifferenz-Entladezustands-Kennlinien erforderlich, aus denen in Abhängigkeit von der Temperatur eine ausgewählt wird.

Bei Verwendung von Batterien mit anderen Zellenspannungen als den genannten 2,1 Volt sind die beschriebenen Verfahren entsprechend anzupassen.

**Patentansprüche**

1. Verfahren zur Überwachung des Ladezustandes einer wiederaufladbaren, verschlossenen Batterie, wobei zumindest die Klemmenspannung gemessen wird, mit folgenden Merkmalen:

   a)
   - die an einer neuen geladenen Batterie üblicherweise anliegende Klemmenspannung ist als Referenzspannung $U_{Ref}$ abgespeichert;

   b)
   - nach einer vollständigen Ladung der Batterie, die nach mindestens einer Belastung durchgeführt wird, wird jeweils die Klemmenspannung $U_{KL}$ gemessen;
   - die Differenzspannung $U_{DKL} = U_{KL} - U_{Ref}$ wird errechnet,
   - zu einer vorher bestimmten Entladeschlußspannung $U_{ES}$ wird die Differenzspannung $U_{DKL}$ addiert und so die korrigierte Entladeschlußspannung $U_{KES} = U_{ES} + U_{DKL}$ berechnet und gespeichert;

   c)
   - zu verschiedenen Zeitpunkten wird die Momentanspannung $U_{ti}$ an den Klemmen gemessen,
   - sobald die Momentanspannung $U_{ti}$ der korrigierten Entladeschlußspannung $U_{KES}$ entspricht, gilt der Entladezustand als erreicht.

2. Verfahren nach Anspruch 1, dadurch gekennzeichnet, daß die Differenzspannung $U_{DKL}$ für den Fall $U_{KL} < U_{Ref}$ nicht errechnet, sondern als $U_{DKL} = 0$ gesetzt wird.

3. Verfahren nach Anspruch 1 oder 2, dadurch gekennzeichnet, daß im Falle $U_{KL} < U_{Ref}$ die Momentanspannung $U_{ti}$ mit der Entladeschlußspannung $U_{ES}$ verglichen und so der Entladezustand ermittelt wird.

4. Verfahren nach einem der Ansprüche 1 bis 3, dadurch gekennzeichnet, daß der Momentanstrom $I_{ti}$ bestimmt, insbesondere gemessen, und die Momentanspannung nur für $I_{ti} = 0$ gemessen und/oder als Meßwert verarbeitet wird.

5. Verfahren nach einem der Ansprüche 1 bis 4, dadurch gekennzeichnet, daß die Momentanspannung $U_{ti}$ kontinuierlich oder zeitdiskret abgetastet und entsprechend die Differenz aus Ruhespannung $U_O$ (korrigierte Entladeschlußspannung $U_{KES}$) und Momentanspannung $U_{ti}$ bestimmt wird.

6. Verfahren nach einem der Ansprüche 1 bis 3, dadurch gekennzeichnet, daß die Momentanspannung $U_{ti}$ zyklisch gemessen und über mehrere Meßwerte ein Mittelwert $U_{ti}$ gebildet wird, der zur Bestimmung des Entladezustands mit der korrigierten Entladeschlußspannung $U_{KES}$ bzw. der Ruhespannung $U_O$ verglichen wird.

7. Verfahren nach einem der Ansprüche 1 bis 6, dadurch gekennzeichnet, daß der Entladezustand als erreicht gilt, sobald die Differenz aus korrigierter Entladeschlußspannung $U_{KES}$ und Momentanspannung $U_{ti}$ einer vorgewählten Spannungsdifferenz entspricht.

8. Verfahren nach einem der Ansprüche 1 bis 7, dadurch gekennzeichnet, daß als Momentanspannung $U_{ti}$ die Spannung $U_{KO}$ eines von der Klemmenspannung gespeisten Kondensators C gemessen wird, wobei sich der Kondensator C bei Belastung der Batterie über eine erste Widerstandsschaltung $R_1$, vorzugsweise mit einer Zeitkonstanten $t_1 > 1$ min. entlädt.

9. Verfahren nach Anspruch 8, dadurch gekennzeichnet, daß der Kondensator C über eine zweite Widerstandsschaltung $R_2$ bei unbelasteter Batterie geladen wird, vorzugsweise mit einer Zeitkonstanten $t_2 < t_1$.

10. Verfahren nach einem der Ansprüche 4 bis 9, dadurch gekennzeichnet, daß der Ladezustand ermittelt wird, indem die Differenz aus Ruhespannung $U_O$ und Momentanspannung $U_{ti}$ mit einem Punkt auf mindestens einer (Entlade-)Spannungsdifferenzkennlinie (u (q)) verglichen wird, wobei die abhängige Variable q der momentane Entladegrad (in Prozent) ist und der Ladezustand sich aus 100 % - q ergibt.

11. Verfahren nach Anspruch 10, dadurch gekennzeichnet, daß mit Hilfe des der Batterie entnommenen Momentanstromes bzw. des zuletzt entnommenen Momentanstromes eine von mehreren Kennlinien zur Bestimmung des momentanen Entladegrades ermittelt wird, vorzugsweise durch Mittelung des Momentanstromes über die Zeit.

12. Verfahren nach einem der Ansprüche 1 bis 6 und/oder Anspruch 8 oder 9, dadurch gekennzeichnet, daß der Ladezustand ermittelt wird, indem die Differenz aus korrigierter Entladeschlußspannung $U_{KES}$ und Momentanspannung $U_{ti}$ mit einem Punkt auf mindestens einer (Entlade-)Spannungsdifferenzkennlinie (u (q)) verglichen wird, wobei die abhängige Variable q der momentane Entladegrad (in Prozent) ist und der Ladezustand sich aus 100 % - q ergibt.

13. Verfahren nach Anspruch 12, dadurch gekennzeichnet, daß mit Hilfe des der Batterie entnommenen Momentanstromes bzw. des zuletzt entnommenen Momentanstromes eine von mehreren Kennlinien zur Bestimmung des momentanen Entladegrades ermittelt wird, vorzugsweise durch Mittelung des Momentanstromes über die Zeit.

## Claims

1. Method for monitoring the charge state of a rechargeable, sealed battery, at least the terminal voltage being measured, having the following features:

a)
- the terminal voltage which is normally present on a new charged battery is stored as the reference voltage $U_{Ref}$

b)
- the terminal voltage $U_{KL}$ is in each case measured after complete charging of the battery, which is carried out after at least one load;
- the difference voltage $U_{DKL} = U_{KL} - U_{Ref}$ is calculated,
- the difference voltage $U_{DKL}$ is added to a previously determined final discharge voltage $U_{ES}$, and the corrected final discharge voltage $U_{KES} = U_{ES} + U_{DKL}$ is thus calculated and stored;

c)
- the instantaneous voltage $U_{ti}$ at the terminals is measured at various times,
- as soon as the instantaneous voltage $U_{ti}$ corresponds to the corrected final discharge voltage $U_{KES}$, the discharge state is regarded as having been reached.

2. Method according to Claim 1, characterized in that the difference voltage $U_{DKL}$ is not calculated for the case $U_{KL} < U_{Ref}$, but is set to $U_{DKL} = 0$.

3. Method according to Claim 1 or 2, characterized in that, in the case where $U_{KL} < U_{Ref}$, the instantaneous voltage $U_{ti}$ is compared with the final discharge voltage $U_{ES}$, and the discharge state is thus determined.

4. Method according to one of Claims 1 to 3, characterized in that the instantaneous current $I_{ti}$ is determined, especially measured, and the instantaneous voltage is measured only for $I_{ti} = 0$ and/or is processed as a measurement.

5. Method according to one of Claims 1 to 4, characterized in that the instantaneous voltage $U_{ti}$ is sampled continuously or at discrete times and is determined in accordance with the difference between the quiescent voltage $U_0$ (corrected final discharge voltage $U_{KES}$) and the instantaneous voltage $U_{ti}$.

6. Method according to one of Claims 1 to 3, characterized in that the instantaneous voltage $U_{ti}$ is measured cyclically and a mean value $U_{ti}$ is formed over a plurality of measurements, which mean value $U_{ti}$ is compared with the corrected final discharge voltage $U_{KES}$ or the quiescent voltage $U_0$ in order to determine the discharge state.

7. Method according to one of Claims 1 to 6, characterized in that the discharge state is regarded as having been reached as soon as the difference between the corrected final discharge voltage $U_{KES}$ and the instantaneous voltage $U_{ti}$ corresponds to a preselected voltage difference.

8. Method according to one of Claims 1 to 7, characterized in that the voltage $U_{KO}$ of a capacitor C which is supplied by the terminal voltage is measured as the instantaneous voltage $U_{ti}$, the capacitor C being discharged, when the battery is loaded, via a first resistance circuit $R_1$, preferably with a time constant of $t_1 > 1$ minute.

9. Method according to Claim 8, characterized in that the capacitor C is charged via a second resistance circuit $R_2$ when the battery is not loaded, preferably with a time constant of $t_2 < t_1$.

10. Method according to one of Claims 4 to 9, characterized in that the charge state is determined in that the difference between the quiescent voltage $U_0$ and the instantaneous voltage $U_{ti}$ is compared with a point on at least one (discharge) voltage-difference characteristic (u (q)), the dependent variable q being the instantaneous discharge level (as a percentage) and the charge state resulting from 100% - q.

11. Method according to Claim 10, characterized in that one of a plurality of characteristics is determined, with the aid of the instantaneous current taken from the battery or of the instantaneous current which was last taken, in order to determine the instantaneous discharge level, preferably by averaging the instantaneous current over the time.

12. Method according to one of Claims 1 to 6 and/or Claim 8 or 9, characterized in that the charge state is determined in that the difference between the corrected final discharge voltage $U_{KES}$ and the instantaneous voltage $U_{ti}$ is compared with a point on at least one (discharge) voltage-difference characteristic (u (q)), the dependent variable q being the instantaneous discharge level (as a percentage) and the charge state resulting from 100% - q.

13. Method according to Claim 12, characterized in that one of a plurality of characteristics is determined, with the aid of the instantaneous current taken from the battery or of the instantaneous current which was last taken, in order to determine the instantaneous discharge level, preferably by averaging the instantaneous current over the time.

**Revendications**

1. Procédé de contrôle de l'état de charge d'une batterie d'accumulateurs fermée rechargeable dans lequel est mesurée au moins la tension aux bornes de la batterie, ayant les caractéristiques suivantes :

   a)
      - la tension usuelle aux bornes d'une batterie neuve chargée est enregistrée comme tension de référence $U_{ref}$,
   b)
      - après une charge complète de la batterie faite après au moins un chargement, la tension aux bornes $U_{KL}$ est mesurée,
      - la différence de tension $U_{DKL} = U_{KL} - U_{ref}$ est calculée,
      - cette différence de tension $U_{DKL}$ est ajoutée à une tension de fin de décharge $U_{ES}$ déterminée préalablement et la tension de fin de décharge corrigée $U_{KES} = U_{ES} + U_{DKL}$ est ainsi calculée et enregistrée,
   c)
      - la tension instantanée $U_{ti}$ aux bornes est mesurée à différents instants,
      - dès que cette tension instantanée $U_{ti}$ correspond à la tension de fin de décharge corrigée $U_{KES}$, l'état déchargé est considéré comme atteint.

2. Procédé selon la revendication 1, caractérisé par le fait que dans le cas $U_{KL} < U_{ref}$, la différence de tension $U_{DKL}$ n'est pas calculée, mais posée égale à zéro.

3. Procédé selon l'une des revendications 1 et 2, caractérisé par le fait que dans le cas $U_{KL} < U_{ref}$, la tension instantanée $U_{ti}$ est comparée à la tension de fin de décharge $U_{ES}$ et l'état déchargé est ainsi déterminé.

4. Procédé selon l'une des revendications 1 à 3, caractérisé par le fait que le courant instantané $U_{ti}$ est déterminé, en particulier mesuré, et la tension instantanée n'est mesurée et/ou utilisée comme valeur mesurée que pour $U_{ti} = 0$.

5. Procédé selon l'une des revendications 1 à 4, caractérisé par le fait que la tension instantanée $U_{ti}$ est lue de façon continue ou discontinue et la différence entre la tension de repos $U_O$ (tension de fin de décharge corrigée $U_{KES}$) et la tension instantanée $U_{ti}$ est déterminée en conséquence.

6. Procédé selon l'une des revendications 1 à 3, caractérisé par le fait que la tension instantanée $U_{ti}$ est mesurée cycliquement et il est établi une moyenne $\overline{U_{ti}}$ de plusieurs valeurs mesurées qui, pour la détermination de l'état déchargé, est comparée à la tension de fin de charge corrigée $U_{KES}$ ou à la tension de repos $U_O$.

7. Procédé selon l'une des revendications 1 à 6, caractérisé par le fait que l'état déchargé est considéré comme atteint dès que la différence entre la tension de fin de décharge corrigée $U_{KES}$ et la tension instantanée $\overline{U_{ti}}$ correspond à une différence de tension choisie à l'avance.

8. Procédé selon l'une des revendications 1 à 7, caractérisé par le fait que comme tension instantanée $U_{ti}$ est mesurée la tension $U_{KO}$ aux bornes d'un condensateur C alimenté par la tension aux bornes de la batterie, ce condensateur C se déchargeant à l'état de déchargement de la batterie par un premier circuit résistant $R^1$, de préférence avec une constante de temps t1 > 1 min.

9. Procédé selon la revendication 8, caractérisé par le fait que le condensateur C est chargé à l'état à vide de la batterie par un deuxième circuit résistant R2, de préférence avec une constante de temps t2 < t1.

10. Procédé selon l'une des revendications 4 à 9, caractérisé par le fait que l'état de charge est déterminé par comparaison de la différence entre la tension de repos $U_O$ et la tension instantanée $U_{ti}$ à un point d'au moins une courbe caractéristique de différence de tension (de décharge) (u (q)), la variable dépendante q étant le degré de décharge instantané (en pour cent) et l'état de charge étant donné par 100 % - q.

11. Procédé selon la revendication 10, caractérisé par le fait qu'à l'aide du courant instantané tiré de la batterie ou du courant instantané tiré en dernier lieu, est déterminée l'une de plusieurs courbes caractéristiques pour la détermination du degré de décharge instantané, de préférence par formation de moyenne dans le temps du courant instantané.

12. Procédé selon l'une des revendications 1 à 6 et/ou des revendications 8 et 9, caractérisé par le fait que l'état de charge est déterminé par comparaison de la différence entre la tension de fin de décharge corrigée $U_{KES}$ et la tension instantanée $U_{ti}$ à un point d'au moins une courbe caractéristique de différence de tension (de décharge) (u (q)), la variable dépendante q étant le degré de décharge instantané (en pour cent) et l'état de charge étant donné par 100 % - q.

13. Procédé selon la revendication 12, caractérisé par la fait qu'à l'aide du courant instantané tiré de la batterie ou du courant instantané tiré en dernier lieu est déterminée l'une de plusieurs courbes caractéristiques pour la détermination du degré de décharge instantané, de préférence par formation de moyenne dans le temps du courant instantané.

Fig. 1

Fig. 2